# EUROPEAN PATENT APPLICATION

(11) **EP 3 594 993 A1**
(43) Date of publication of application: **15.01.2020**
(21) Application number: 17901582.1
(22) Date of filing: 31.10.2017
(51) Int. Cl.: H01L 21/336, H01L 29/786

(54) **METHOD FOR MANUFACTURING UNIT CELL STRUCTURE OF SILICON CARBIDE MOSFET**

(30) Priority: 20.03.2017 CN 201710166459
(71) Applicant: China Electronics Technology Group Corporation No.55 Research Institute, Nanjing, Jiangsu 210016 (CN)
(72) Inventor: HUANG, Runhua, Nanjing Jiangsu 210016 (CN); BAI, Song, Nanjing Jiangsu 210016 (CN); TAO, Yonghong, Nanjing Jiangsu 210016 (CN); WANG, Ling, Nanjing Jiangsu 210016 (CN)
(74) Representative: Hanna Moore + Curley
(86) International application number: PCT/CN2017/108487
(87) International publication number: WO 2018/171197

(57) **Abstract**

The invention discloses a method for manufacturing a SiC MOSFET single-cell structure, wherein a vertical conducting channel region is designed in a curved shape, so that a total length of the vertical conducting channel region can be effectively increased, thus reducing a proportion of a channel resistance in an on-resistance.

## Description

### TECHNICAL FIELD

The present invention relates to the field of semiconductor devices, and more particularly, to a method for manufacturing a SiC MOSFET single-cell structure.

### BACKGROUND

SiC materials have high performances of wide forbidden gap, high breakdown electric field, high saturated drift velocity and good thermal conductivity, which enable them to become ideal materials for manufacturing a device with high power, high frequency, high temperature resistance and radiation resistance. A SiC MOSFET device has a series of advantages such as high breakdown voltage, high current density and a driving circuit similar to a silicon IGBT, thus having a wide development prospect. Meanwhile, SiC is the only wide bandgap semiconductor material that can realize a high-quality gate oxide layer through self-oxidation. However, a thermal oxidation technology of SiC is not yet mature at present, and a channel formed has a very low mobility, so that a channel resistance accounts for a very large proportion of resistance in a current flow path, thus severely restricting the improvement of a conduction performance of the device.

### SUMMARY

Object of the present invention: the present invention is intended to provide a method for manufacturing a SiC MOSFET single-cell structure, which can effectively reduce a proportion of a channel resistance in an on-resistance.

Technical solution: the method for manufacturing a SiC MOSFET single-cell structure according to the present invention comprises the following steps of:
S1: manufacturing an ion implantation mask on a surface of a SiC epitaxial layer, removing an ion implantation mask in a PWELL-doped region, and reserving an ion implantation mask in a vertical conducting channel region, wherein the vertical conducting channel region is curved;
S2: implanting first-type ions on a whole wafer to form a PWELL implantation region, wherein the first-type ion is a P-type ion;
S3: manufacturing an N-region implantation mask: manufacturing an ion implantation mask on a surface of a SiC epitaxial layer, and removing an ion implantation mask in an N-doped region;
S4: implanting second-type ions on a whole wafer to form an N-implantation region, wherein the channel region comprises a first channel region, a second channel region and a third channel region, and lengths of the channels are sequentially reduced; the second-type ion is an N-type ion; and a channel length of the first channel region needs to be ensured to be sufficient to resist a blocking voltage, due to a pinch-off effect of adjacent first channel regions, short channels can be used in the second channel region and the third channel region, and the device can be ensured to have sufficient blocking performance;
S5: manufacturing an N+-region implantation mask: manufacturing an ion implantation mask on a surface of a SiC epitaxial layer, and removing an ion implantation mask in an N+-doped region;
S6: implanting second-type ions on a whole wafer to form an N+-implantation region;
S7: manufacturing a P+-region implantation mask: manufacturing an ion implantation mask on a surface of a SiC epitaxial layer, and removing an ion implantation mask in a P+-doped region;
S8: implanting first-type ions on a whole wafer;
S9: activating implanted impurities through high-temperature activated annealing;
S10: removing a gate dielectric of an ohmic contact region;
S11: manufacturing an ohmic contact metal layer;
S12: forming P-type and N-type ohmic contacts while annealing;
S13: manufacturing a gate electrode in a gate electrode region to cover all the channel regions; and
S14: performing gate-source isolation and metal thickening.

Further, a fourth channel region is added between adjacent first channel regions, so that a blocking capability of a single-cell structure can be enhanced.

Further, the P+-doped region comprises a plurality of diamond-shaped P+-doped units, all the P+-doped units are arranged in a straight line, and two adjacent P+-doped units are connected through a vertex. In this way, a current path can be effectively reduced, thus reducing an on-resistance. In addition, since no distance exists between two adjacent P+-doped units and no distance exists between an edge of the P+-doped region and an edge of the ohmic contact region, a processing difficulty is reduced.

Further, a length of the first channel region is 0.5 um to 1.5 um.

Further, a length of the second channel region is 0.2 um to 1.5 um.

Further, a length of the third channel region is 0.1 um to 1.5 um.

Further, a length of the fourth channel region is 0.1 um to 1.5 um.

Further, a doped concentration of the N-implantation region is 1e16-5E19 cm⁻², and a doped concentration of the N+-implantation region is 1e18-1E21 cm⁻².

Beneficial effects: the present invention discloses a method for manufacturing a SiC MOSFET single-cell structure, wherein the vertical conducting channel region is designed in a curved shape, so that a total length of the vertical conducting channel region can be effectively increased, and meanwhile, the short channel can be used without worrying about premature breakdown of the device caused by short channel punch-through, thus reducing the proportion of the channel resistance in the on-resistance.

### BRIEF DESCRIPTION OF THE DRAWINGS

Fig. 1 is a diagram illustrating PWELL-ion implantation according to a specific embodiment of the present invention;
Fig. 2 is a diagram illustrating N-ion implantation according to a specific embodiment of the present invention;
Fig. 3 is a diagram illustrating N+-ion implantation according to a specific embodiment of the present invention;
Fig. 4 is a diagram illustrating P+-ion implantation according to a specific embodiment of the present invention;
Fig. 5 is a diagram illustrating ohmic contact according to a specific embodiment of the present invention;
Fig. 6 is an exploded diagram of a channel according to a specific embodiment of the present invention;
Fig. 7 is a structure diagram of a specific embodiment of the present invention added with a fourth channel region;
Fig. 8 is a diagram of a square P+-region in the prior art; and
Fig. 9 is a diagram of a diamond-shaped P+-region according to a specific embodiment of the present invention.

### DETAILED DESCRIPTION

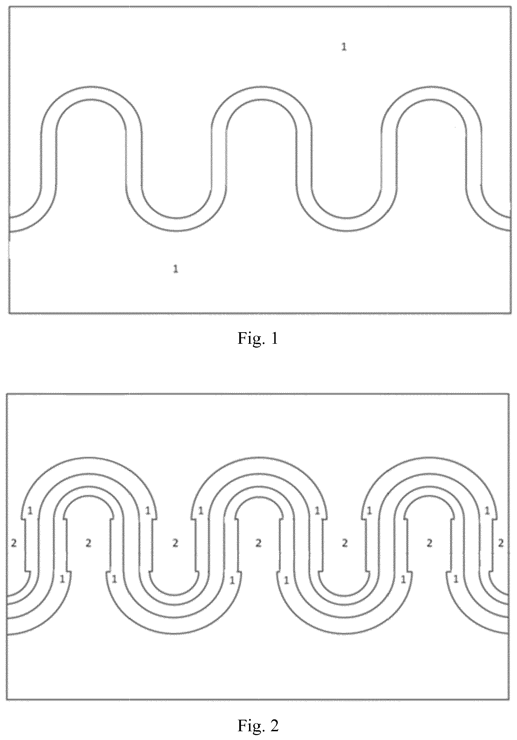

In S1, as shown in Fig. 1, an ion implantation mask is manufactured on a surface of a SiC epitaxial layer, an ion implantation mask in a PWELL-doped region 1 is removed, and an ion implantation mask in a vertical conducting channel region is reserved, wherein the vertical conducting channel region is curved as shown in Fig. 1.

In S2, first-type ions are implanted on a whole wafer to form a PWELL region, wherein the first-type ion is a P-type ion.

In S3, as shown in Fig. 2, an ion implantation mask is manufactured on a surface of a SiC epitaxial layer, and an ion implantation mask in an N-doped region 2 is removed.

In S4, second-type ions are implanted on a whole wafer to form an N-implantation region, wherein the channel region comprises a first channel region 6, a second channel region 7 and a third channel region 8, and lengths of the channels are sequentially reduced; and the second-type ion is an N-type ion.

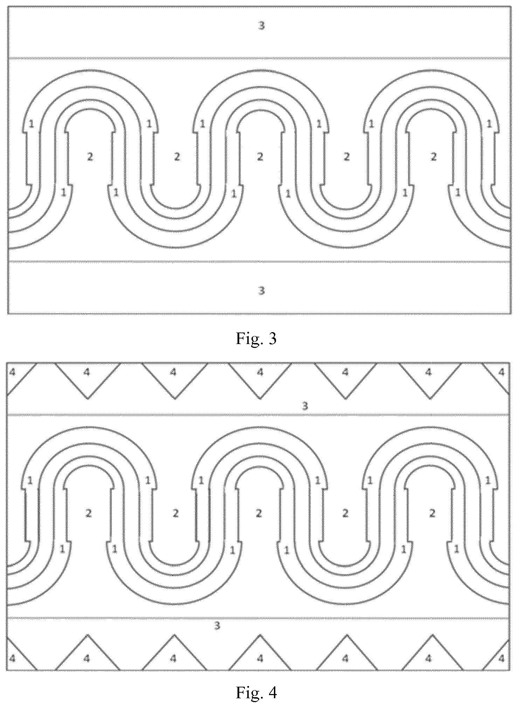

In S5, as shown in Fig. 3, an ion implantation mask is manufactured on a surface of a SiC epitaxial layer, and an ion implantation mask in an N+-doped region 3 is removed.

In S6, second-type ions are implanted on a whole wafer to form an N+-implantation region.

In S7, as shown in Fig. 4, an ion implantation mask is manufactured on a surface of a SiC epitaxial layer, and an ion implantation mask in a P+-doped region 4 is removed.

In S8, first-type ions are implanted on a whole wafer.

In S9, implanted impurities are activated through high-temperature activated annealing.

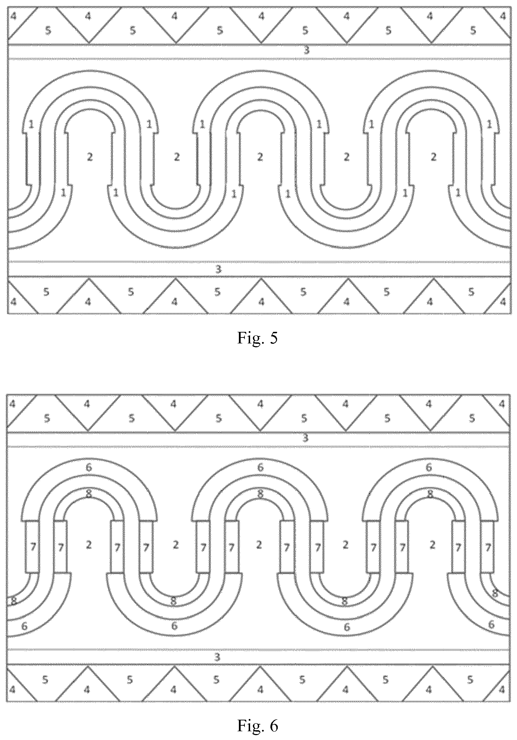

In S10, as shown in Fig. 5, a gate dielectric is manufactured, and gate dielectrics in an N-type ohmic contact region 5 and a P-type ohmic contact region 4 are removed.

In S11, a metal layer is manufactured on the N-type ohmic contact region 5 and the P-type ohmic contact region 4.

In S12, the metal layer, and P-type and N-type ohmic contacts between the N-type ohmic contact region 5 and the P-type ohmic contact region 4 are formed while annealing.

In S13, a gate electrode is manufactured in a gate electrode region to cover all the channel regions.

In S14, gate-source isolation and metal thickening are performed.

The "P+-doped region" is the "P-type ohmic contact region".

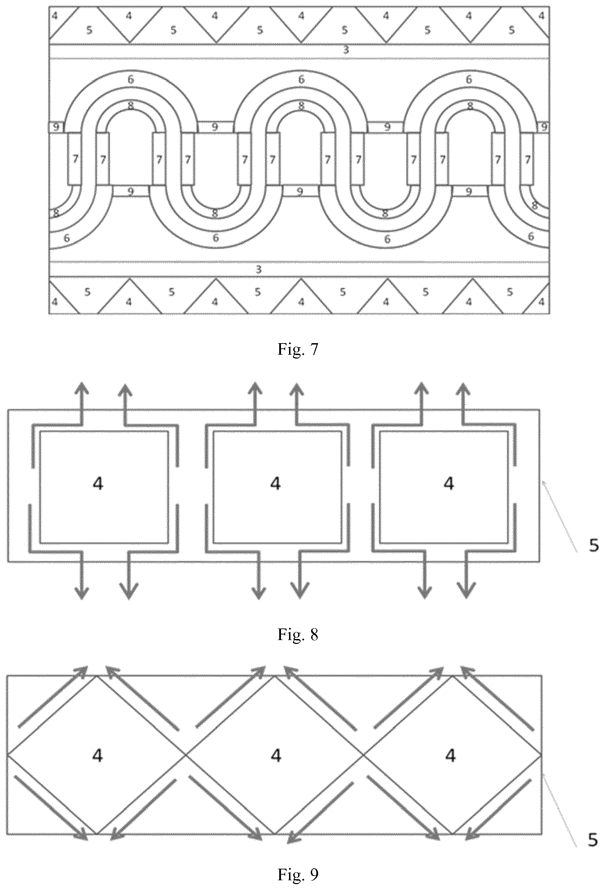

The P+-doped region 4 in the prior art is shown in Fig. 8, the P+-doped region 4 comprises a plurality of square P+-doped units, a certain distance exists between two adjacent P+-doped units, and a certain distance exists between an upper edge of the P+-doped unit and an upper edge of the N-type ohmic contact region 5, and between a lower edge of the P+-doped unit and a lower edge of the N-type ohmic contact region 5. In addition, as shown in Fig. 8, current flows along two adjacent sides of a square, a current path is relatively long, and an on-resistance is large. Meanwhile, a width of the N-type ohmic contact region 5 is larger than a width of the P+-doped region 4, and considering the flowing of the current and a photoetching error, a difference value in width is ensured to be large enough.

In order to solve the problems in the prior art, the P+-doped region 4 of the specific embodiment comprises a plurality of diamond-shaped P+-doped units as shown in Fig. 9, all the P+-doped units are arranged in a straight line, and two adjacent P+-doped units are connected through a vertex. As shown in Fig. 9, the current flows along one side of the diamond shape, which can effectively reduce the current path, thus reducing the on-resistance. In addition, since no distance exists between two adjacent P+-doped units and no distance exists between an edge of the P+-doped region 4 and an edge of the N-type ohmic contact region 5, a processing difficulty is reduced. A change in resistance of a transverse current path caused by a structure process error as shown in Fig. 8 cannot be caused.

As shown in Fig. 4, Fig. 5 Fig. 6 and Fig. 7, the P+-doped region 4 comprises a plurality of diamond-shaped P+-doped units, all the P+-doped units are arranged in a straight line, and two adjacent P+-doped units are connected through a vertex. In this way, the current path can be effectively reduced, thus reducing the on-resistance. In addition, since a current path of the N+-region along a horizontal direction does not need to be reserved, sufficient redundancy does not need to be reserved between the ohmic contact region and the P+-doped region 4.

In addition, a fourth channel region 9 can also be added between adjacent first channel regions 6, as shown in Fig. 7, to enhance a device blocking capability.

## Claims

1. A method for manufacturing a SiC MOSFET single-cell structure, comprising the following steps of:
S1: manufacturing an ion implantation mask on a surface of a SiC epitaxial layer, removing an ion implantation mask in a PWELL-doped region, and reserving an ion implantation mask in a vertical conducting channel region, wherein the vertical conducting channel region is curved;
S2: implanting first-type ions on a whole wafer to form a PWELL implantation region, wherein the first-type ion is a P-type ion;
S3: manufacturing an N-region implantation mask: manufacturing an ion implantation mask on a surface of a SiC epitaxial layer, and removing an ion implantation mask in an N-doped region;
S4: implanting second-type ions on a whole wafer to form an N-implantation region, wherein the channel region comprises a first channel region, a second channel region and a third channel region, and lengths of the channels are sequentially reduced; and the second-type ion is an N-type ion;
S5: manufacturing an N+-region implantation mask: manufacturing an ion implantation mask on a surface of a SiC epitaxial layer, and removing an ion implantation mask in an N+-doped region;
S6: implanting second-type ions on a whole wafer to form an N+-implantation region;
S7: manufacturing a P+-region implantation mask: manufacturing an ion implantation mask on a surface of a SiC epitaxial layer, and removing an ion implantation mask in a P+-doped region;
S8: implanting first-type ions on a whole wafer;
S9: activating implanted impurities through high-temperature activated annealing;
S10: removing a gate dielectric of an ohmic contact region;
S11: manufacturing an ohmic contact metal layer;
S12: forming P-type and N-type ohmic contacts while annealing;
S13: manufacturing a gate electrode in a gate electrode region to cover all the channel regions; and
S14: performing gate-source isolation and metal thickening.

2. The method for manufacturing a SiC MOSFET single-cell structure according to claim 1, wherein a fourth channel region is added between adjacent first channel regions.

3. The method for manufacturing a SiC MOSFET single-cell structure according to claim 1, wherein the P+-doped region comprises a plurality of diamond-shaped P+-doped units, all the P+-doped units are arranged in a straight line, and two adjacent P+-doped units are connected through a vertex.

4. The method for manufacturing a SiC MOSFET single-cell structure according to claim 1, wherein a length of the first channel region is 0.5 um to 1.5 um.

5. The method for manufacturing a SiC MOSFET single-cell structure according to claim 1, wherein a length of the second channel region is 0.2 um to 1.5 um.

6. The method for manufacturing a SiC MOSFET single-cell structure according to claim 1, wherein a length of the third channel region is 0.1 um to 1.5 um.

7. The method for manufacturing a SiC MOSFET single-cell structure according to claim 2, wherein a length of the fourth channel region is 0.1 um to 1.5 um.

8. The method for manufacturing a SiC MOSFET single-cell structure according to claim 1, wherein a doped concentration of the N-implantation region is 1e16-5E19 cm⁻², and a doped concentration of the N+-implantation region is 1e18-1E21 cm⁻².
